(19) Europäisches Patentamt
European Patent Office
Office européen des brevets

(11) **EP 3 180 403 B1**

(12) **EUROPEAN PATENT SPECIFICATION**

(45) Date of publication and mention
of the grant of the patent:
**28.11.2018 Bulletin 2018/48**

(51) Int Cl.:
*C09D 5/24* (2006.01)          *H01B 1/22* (2006.01)
*B82Y 30/00* (2011.01)          *C09D 7/40* (2018.01)
*H01B 1/02* (2006.01)

(21) Application number: **15750987.8**

(22) Date of filing: **11.08.2015**

(86) International application number:
**PCT/EP2015/068424**

(87) International publication number:
**WO 2016/023889 (18.02.2016 Gazette 2016/07)**

(54) **COMPOSITION COMPRISING SILVER NANOWIRES AND DISPERSED POLYMER BEADS FOR THE PREPARATION OF ELECTROCONDUCTIVE TRANSPARENT LAYERS**

ZUSAMMENSETZUNG ENTHALTEND SILBERNANODRÄHTE UND DISPERGIERTE POLYMERTEILCHEN FÜR DIE HERSTELLUNG VON ELEKTRISCH LEITENDEN SCHICHTEN

COMPOSITION COMPRENANT DES NANOFILS D'ARGENT ET DES PERLES DE POLYMÈRES DISPERSÉES POUR LA PRÉPARATION DE COUCHES TRANSPARENTES ELECTROCONDUCTRICES

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **15.08.2014 US 201462037635 P**

(43) Date of publication of application:
**21.06.2017 Bulletin 2017/25**

(60) Divisional application:
**18199114.2**

(73) Proprietor: **BASF SE**
**67056 Ludwigshafen am Rhein (DE)**

(72) Inventors:
• **DIETSCH, Herve**
  **67098 Bad Dürkheim (DE)**
• **STURM, Thomas**
  **67105 Schifferstadt (DE)**
• **SEYFRIED, Danny**
  **67067 Ludwigshafen (DE)**
• **BARTELS, Frank**
  **64625 Bensheim (DE)**
• **ZHANG, Rui**
  **West New York, New Jersey 07093 (US)**

(74) Representative: **BASF IP Association**
**BASF SE**
**G-FLP-C006**
**67056 Ludwigshafen (DE)**

(56) References cited:
WO-A1-2008/031015          WO-A1-2011/008227
WO-A2-2007/022226          WO-A2-2013/192437
US-A1- 2014 255 707

**Description**

The present invention relates to a composition suitable for the preparation of an electroconductive transparent layer. a method for preparing an electroconductive transparent layer, an electroconductive transparent layer comprising or consisting of solid constituents of said composition, an article comprising said electroconductive transparent layer, and to the use of said composition for the preparation of said electroconductive layer or said article, respectively.

The term "electroconductive transparent layer" as used herein refers to a layer which (i) is capable of allowing the flow of an electric current when an appropriate voltage is applied and (ii) has a light transmission of 80 % or more in the visible region (400-700 nm) measured according to ASTM D1003, see e.g. US 8,049,333. Usually, said layer is arranged on the surface of a substrate, wherein said substrate is typically an electrical isolator. Such electroconductive transparent layers are widely used in flat liquid crystal displays, touch panels, electroluminescent devices, thin film photovoltaic cells, as anti-static layers and as electromagnetic wave shielding layers.

Typically, such electroconductive transparent layer is a composite comprising (i) an optically transparent solid contiguous phase (also referred to as a matrix) and (ii) a conductive network of electroconductive nanoobjects which extends throughout said matrix. The matrix is formed of one or more optically transparent polymers. Said matrix binds the electroconductive nanoobjects within the layer, fills the voids between said electroconductive nanoobjects, provides mechanical integrity and stability to the layer and binds the layer to the surface of the substrate. The conductive network of electroconductive nanoobjects allows for the flow of an electric current between adjacent and overlapping electroconductive nanoobjects within the layer. Due to the small dimensions of the nanoobjects, their influence on the optical behavior of the composite is quite small, thus allowing for the formation of an optically transparent composite, i.e. a composite having a light transmission of 80 % or more in the visible region (400-700 nm) measured according to ASTM D1003, see e.g. US 8,049,333.

Typically, such electroconductive transparent layers are prepared by applying a composition comprising sufficient amounts of

(i) one or more matrix-forming binding agents,

(ii) electroconductive nanoobjects and

(iii) optionally auxiliary constituents

dissolved or dispersed in a suitable liquid (preferably water) to a surface of a substrate, and removing those constituents which at 25 °C and 101,325 kPa are liquid (hereinbelow referred to as the liquid constituents) from said composition applied to said surface of said substrate to such extent that on said surface of said substrate an electroconductive transparent layer is formed which comprises constituents of the applied composition which at 25 °C and 101,325 kPa are solid (hereinbelow referred to as solid constituents). Such a composition for the preparation of an electroconductive transparent layer is commonly referred to as an ink.

Typically, polymers which are soluble in the liquid of the ink are used as matrix-forming binding agents. More specifically, in water-based inks typically water-soluble polymers are used as matrix-forming binding agents. For instance, US 2008/0182090 A1 discloses a composition which is suitable for use as an ink for high speed printing for producing electronic circuitry such as RFID antennas etc., said composition comprising the following constituents

(a) conductive particles, preferably silver particles, more preferably silver flakes

(b) a water-soluble styrene/(meth)acrylic copolymer

(c) an anionic wetting agent

(d) defoamer and

(e) water.

According to US 2008/0182090 A1, the obtained electroconductive layers have a thickness in the range of from 3 μm to 7 μm.

Preferably, in said ink according to US 2008/0182090 A1, the concentration of silver particles (a) is about 10 to 90 % of the composition, and the concentration the copolymer (b) is about 2 to 50 % of the composition. Accordingly, the concentration of constituents which at 25 °C and 101.325 kPa are solid (hereinbelow referred to as solid constituents) is remarkably high in said ink. US 2008/0182090 A1 is silent regarding the optical properties of the obtained electroconductive layers, however it is assumed that the light transmission is rather low and the haze is rather high because of the large amount of solid constituents in the ink. At a given wet thickness of the ink applied to the surface of a substrate for the preparation of an electroconductive layer, the thickness and accordingly the opacity of the obtainable electroconductive layer increases with increasing concentration of solid constituents in the applied ink. Decreasing the thickness and opacity of the obtainable electroconductive layer by decreasing the wet thickness is hardly possible, because for technical reasons there is a lower limit of the wet thickness, and in order to obtain an electroconductive transparent layer at all, the wet thickness must be as close to said lower limit as possible.

US 2014/0255707 A1 discloses that certain compounds comprising at least one carboxyl group have been found to provide anti-corrosion properties when incorporated into silver nanowire containing films.

WO 2013/192437 A2 discloses a material comprising a transparent conductive coating and a substrate on which the coating is supported, the coating comprising a fused metal nanowire network comprising fused metal nanowires, wherein the coating has a transparency to visible light of at least about 85% and a sheet resistance of no more than about 100 Ohms/square or a transparency to visible light of at least about 90% and a sheet resistance of no more than about 250 Ohms/square.

WO 2013/175227 A1 discloses a method of preparing a transparent, electrically-conductive solid material, typically a coating.

WO 2011/115603 A1 discloses 1,2-diazine compounds which have been found to provide anti-corrosion properties when incorporated into silver nanowire containing films.

WO 2011/008227 A1 discloses that transparent conductive films comprising silver nanowires dispersed in polyvinyl alcohol or gelatin can be prepared by coating from aqueous solvent using common aqueous solvent coating techniques.

Transparent electroconductive layers obtained using water-soluble polymers as binding agents and matrix formers may be moisture-sensitive, due to the solubility of the binding agent in water. Thus, in the presence of moisture, there is a risk that a transparent electroconductive layer containing a matrix formed of water-soluble polymers swells and loses its integrity and/or adhesion to the substrate. It is therefore an object of the present invention to provide an ink suitable for the preparation of an electroconductive transparent layer having increased stability against moisture without compromising the optical properties of the layer.

It is also an object of the present invention to provide an ink suitable for the preparation of an electroconductive transparent layer having a light transmission of 80 % or more measured according to ASTM D1003 (Procedure A). Further preferably, said electroconductive transparent layer shall exhibit a sheet resistance of 1000 Ohm/square or less as measured by the four point probe. Further preferably, said electroconductive transparent layer shall exhibit a haze of 2 % or less as measured according to ASTM D1003 (Procedure A), and a sheet resistance of 1000 Ohm/square or less as measured by the four point probe. In the context of the present invention, any reference to ASTM D1003 refers to the version published in November 2013.

These and other objects are achieved by a composition according to the present invention, said composition comprising the constituents

(A) water,

(B) electroconductive nanoobjects,
said electroconductive nanoobjects (B) having two external dimensions in the range of from 1 nm to 100 nm and their third external dimension in the range of from 1 $\mu$m to 100 $\mu$m,
wherein the weight fraction of said electroconductive nanoobjects (B) is in the range of from 0.01 wt.-% to 1 wt.-% based on the total weight of the composition,

(C) dispersed in the water, particles of a polymer having a number average molecular weight of 25000 g/mol or higher,

wherein said dispersed particles (C) have a mean diameter in the range of from 10 nm to 1000 nm,
wherein the total weight fraction of said dispersed particles (C) is in the range of from 0.02 wt.-% to 5 wt.-%, based on the total weight of the composition.

Hereinbelow, a composition according to the invention (as defined above) is also referred to as an ink. Hereinbelow, the above-defined dispersed particles (C) of a polymer having a number average molecular weight of 25000 g/mol or higher, are also referred to as dispersed polymer beads (C).

Surprisingly, it has been found that a composition as defined above which comprises a binding agent in the form of the above-defined dispersed polymer particles (C) is suitable for the preparation of electroconductive transparent layers having favorable optical properties as well as satisfying electronic conductivity and improved stability against moisture.

In the composition according to the invention (as defined above), the main constituent which at 25 °C and 101.325 kPa is liquid, is water (A), and the main constituents which at 25 °C and 101.325 kPa are solid, are the above-defined electroconductive nanoobjects (B) and the polymer of the above-defined particles (C). In the composition according to the present invention (as defined above), the total concentration of constituents which at 25 °C and 101.325 kPa are solid (solid constituents) is 10 wt.-% or less, preferably 8 wt.-% or less, further preferably 5 wt.-% or less, in each case based on the total weight of said composition.

According to ISO/TS 27687:2008 (as published in 2008), the term "nanoobject" refers to an object having one, two or three external dimensions in the nanoscale, i.e. in the size range from approximately 1 nm to 100 nm. The electroconductive nanoobjects to be used for the present invention are electroconductive nanoobjects having two external dimensions in the range of from 1 nm to 100 nm and their third external dimension in the range of from 1 $\mu$m to 100 $\mu$m. Typically, said two external dimensions which are in the range of from 1 nm to 100 nm are similar i.e. they differ in size by less than three times. The third dimension of said electroconductive nanoobjects (B) is significantly larger, i.e. it differs from the other two external dimensions by more than three times.

According to ISO/TS 27687:2008 (as published in 2008), nanoobjects having two similar external dimensions in the nanoscale, while the third external dimension is significantly larger, are generally referred to as nanofibers. Electrically conductive nanofibers are also referred to as nanowires. Hollow nanofibers (irrespective of their electrical conductivity) are also referred to as nanotubes.

Electroconductive nanoobjects (B) as defined above which are to be used for the present invention typically have a cross section close to circular shape. Said cross section extends perpendicularly to said external dimension which is in the range of from 1 $\mu$m to 100 $\mu$m. Thus, said two external dimensions which are in the nanoscale are defined by the diameter of said circular cross section. Said third external dimension extending perpendicularly to said diameter is referred to as the length.

Preferably, a composition according to the present invention comprises electroconductive nanoobjects (B) having a length in the range of from 1 $\mu$m to 100 $\mu$m, preferably of from 3 $\mu$m to 50 $\mu$m, more preferably of from 10 $\mu$m to 50 $\mu$m, and a diameter in the range of from 1 nm to 100 nm, preferably of from 2 nm to 50 nm, more preferably of from 3 nm to 30 nm.

Preferably, in the composition according to the invention (as defined above) the weight fraction of said electroconductive nanoobjects (B) as defined above is 0.8 wt.-% or less, preferably 0.5 wt-% or less, based on the total weight of the composition. The weight fraction of said electroconductive nanoobjects (B) is not less than 0.01 wt.-% based on the total weight of the composition, because a weight fraction of less than 0.01 wt.-% of electroconductive nanoobjects (B) may be not sufficient for forming a conductive network, so that such composition is not suitable for preparing an electroconductive layer. Further preferably the weight fraction of said electroconductive nanoobjects (B) is not less than 0.02 wt.-%, preferably not less than 0.05 wt.-%.

Preferably, in the composition according to the invention (as defined above), the total weight fraction of said dispersed polymer beads (C) is less than 2 wt.-%, more preferably 1.8 wt.-% or less, further preferably 1.5 wt.-% or less, especially preferably 1 wt.-% or less, based on the total weight of the composition. The total weight fraction of said dispersed polymer beads (C) is not less than 0.02 wt.-%, based on the total weight of the composition, because a total weight fraction of less than 0.02 wt.-% of said dispersed polymer beads (C) may be not sufficient for binding the electroconductive nanoobjects (B) so that such composition is not suitable for preparing an electroconductive layer. Further preferably the total weight fraction of said dispersed polymer beads (C) is not less than 0.05 wt.-%, preferably not less than 0.1 wt.-%.

Preferably, in the composition according to the present invention (as defined above) the ratio between the total weight of said electroconductive nanoobjects (B) and the total weight of said dispersed polymer beads (C) is in the range of from 1:20 to 20:1, preferably from 1:10 to 5:1, further preferably from 1:5 to 5:1.

The term "electroconductive nanoobject" means that the nanoobject comprises or consists of one or more materials capable of allowing the flow of electrons. Accordingly, a plurality of such electroconductive nanoobjects may form a conductive network of adjacent and overlapping nanoobjects extending throughout said matrix capable of carrying an electric current, provided that there is sufficient interconnection (mutual contact) between individual electroconductive nanoobjects so as to enable the transport of electrons along the interconnected electroconductive nanoobjects within the network.

Preferably, said electroconductive nanoobjects (B) comprise or consist of one or more materials selected from the group consisting of silver, copper, gold and carbon.

Preferably, the electroconductive nanoobjects (B) have a length in the range of from 1 $\mu$m to 100 $\mu$m and a diameter in the range of from 1 nm to 100 nm, wherein said electroconductive nanoobjects (B) comprise one or more materials selected from the group consisting of silver, copper, gold and carbon.

Preferably, said electroconductive nanoobjects (B) are selected from the group consisting of nanowires and nanotubes. Preferred nanowires comprise or consist of one or more metals selected from the group consisting of silver, copper and gold. Preferably, said nanowires each comprise at least 50 wt.-% of one or more metals selected from the group consisting of silver, copper and gold, based on the total weight of said nanowire. Most preferred are nanowires each comprising 50 wt.-% or more of silver based on the total weight of said nanowire (hereinbelow also referred to as "silver nanowires").

Preferred nanotubes are carbon nanotubes.

Among nanowires and nanotubes, nanowires are preferred.

Most preferred electroconductive nanoobjects (B) according to the present invention are silver nanowires having the above-mentioned dimensions.

Suitable electroconductive nanoobjects (B) as defined above are known in the art and are commercially available.

Silver nanowires (as well as nanowires of other metals) are typically commercially available in the form of an aqueous dispersion wherein polyvinylpyrrolidone is adsorbed onto the surface of the silver nanowires in order to render the dispersion stable. Any matter adsorbed on the surface of the nanowires is not included in the above-defined dimensions and composition of the electroconductive nanoobjects (B).

Preferably, the silver nanowires are obtained by the procedure described by Yugang Sun and Younan Xia in Adv. Mater 2002 14 No. 11. June 5, pages 833-837.

In preferred embodiments the composition according to the present invention does not comprise carbon nanotubes.

Constituent (C) of the composition according to the present invention (as defined above) consists of dispersed particles of a polymer having a number average molecular weight of 25000 g/mol or higher. Preferably, the number average molecular weight of the polymer of the particles (C) is not higher than 200000 g/mol. Said polymer is either a homopolymer or a copolymer. Said particles of constituent (C) are either particles of one kind of polymer or a mixture of particles of different polymers.

Such polymer particles are also referred to as polymer beads. Typically, a polymer bead consists of several entangled polymer chains. Said polymer beads have an average particle diameter in the range from 10 nm to 1000 nm, in particular in the range from 50 nm to 600 nm determined by dynamic light scattering on an aqueous polymer dispersion (from 0.005 to 0.01 percent by weight) at 23 °C by means of an Autosizer IIC from of Malvern Instruments, England.

Typical polymer beads (C) are known in the art and commercially available in the form of aqueous dispersions of said polymer beads (aqueous polymer dispersions). Typically, the dispersed polymers are present in colloidal dispersion. An aqueous colloidal dispersion of polymer particles is also referred to as a latex.

Such aqueous polymer dispersions are obtainable by polymerization of suitable monomers in an aqueous liquid phase, e.g. by means of suspension polymerization or emulsion polymerization. Preferred aqueous polymer dispersions are obtainable by free-radically initiated aqueous emulsion polymerization of ethylenically unsaturated monomers. The free-radically initiated aqueous emulsion polymerization is effected typically in such a way that at least one ethylenically unsaturated monomer, frequently with the additional use of dispersing assistants, is distributed in a disperse manner in aqueous medium and polymerized by means of at least one free-radical polymerization initiator. For further details, reference is made to US 7,999,045 B2 and the prior art cited therein.

Preferable aqueous polymer dispersions are those whose polymers comprise, in copolymerized form, from 50 to 99.9% by weight of

- esters of acrylic acid and/or methacrylic acid with alkanole having from 1 to 12 carbon atoms, or

- styrene, or

- styrene and butadiene, or

- vinyl chloride and/or vinylidene chloride, or

- from 40 to 99.9% by weight of vinyl acetate, vinyl propionate and/or ethylene.

Particularly preferred are polyacrylates, polymethacrylates, copolymers of acrylates and methacrylates, and copolymers of styrene and (meth)acrylates. Herein, the term "(meth)acrylate" includes "methacrylate" and "acrylate"."

The polyacrylates are either homo- or copolymers. In the case of homopolymers the molecules consist of units each derived from the same acrylate monomer. In the case of copolymers the molecules consist of units derived from different acrylate monomers in copolymerized form, said copolymers are also referred to as copolymers of acrylates.

The polymethacrylates are either homo- or copolymers. In the case of homopolymers the molecules consist of units each derived from the same acrylate monomer. In the case of copolymers the molecules consist of units derived from different acrylate monomers in copolymerized form.

In said copolymers of acrylates and methacrylates each molecule comprises or consists of units derived from acrylate monomers and units derived from methacrylate monomers in copolymerized form

In said copolymers of styrene and (meth)acrylates, each molecule comprises or consists of units derived from monoalkenyl aromatic monomers and units derived from (meth)acrylic monomers in copolymerized form.

Colloidal stability of latex is produced by a balancing of electrostatic repulsion, van der Waals attraction and steric attraction or repulsion. The above-defined polymer dispersions typically comprise dispersing assistants which serve to ensure the stability of the aqueous polymer dispersions. Suitable dispersing agents are selected from the group consisting of protective colloids and surfactants. Preferred surfactants are sodium dodecylsulfate (SDS) and water soluble amphiphilic styrene/(meth)acrylic copolymers having a number average molecular weight in the range of from 500 g/mol to 22000 g/mol (copolymers (D) as defined below). Copolymers (D) as defined below are preferred surfactants because they are capable of co-acting with the polymer beads (C) in forming a matrix and binding the above-defined electroconductive nanoobjects (B).

In preferred embodiments the composition according to the present invention (as defined above) consists of the constituents (A), (B) and (C) as defined above and dispersing assistants (as defined above) which serve to keep the polymer beads (C) in a dispersed state within the composition.

In alternative preferred embodiments, the composition according to the present invention (as defined above) comprises one or more further constituents which are capable of co-acting with the above-defined polymer beads (C) in forming a matrix and binding the above-defined electroconductive nanoobjects (B). Those constituents are referred to as additional binding agents and belong to the solid constituents of the composition. Those additional binding agents are selected from the group of substances which are capable of forming a matrix and binding the above-defined electroconductive nanoobjects (B) in the absence of any polymer beads (C) (as defined above). Those additional binding agents are not selected from the group consisting of the above-defined polymer beads (C) and electroconductive nanoobjects (B) as defined above. Preferably, the total weight fraction of said additional binding agents (based on the total weight of the composition) is equal to or less than the total weight fraction of said dispersed polymer beads (C) based on the total weight of the composition.

In the composition according to the invention, the total weight fraction of said dispersed polymer beads (C) and said one or more additional binding agents as defined above is preferably 7.5 wt.-% or less, preferably 3 wt.-% or less, further preferably 2.25 wt.-% or less, based on the total weight of the composition. Preferably, the total weight fraction of said additional binding agents (based on the total weight of the composition) is equal to or less of the total weight fraction of said dispersed polymer beads (C) based on the total weight of the composition.

Preferably, said additional binding agents comprised by the composition according to the present invention (as defined above) are selected from the group consisting of

(D) dissolved in the water one or more styrene/(meth)acrylic copolymers, said dissolved copolymers (D) each having a number average molecular weight in the range of from 500 g/mol to 22000 g/mol,

(E) dispersed in the water, fibers of crystalline cellulose, said dispersed fibers (E) of crystalline cellulose having a length in the range of from 80 nm to 300 nm and a diameter in the range of from 5 nm to 30 nm,

(F) dissolved in the water, one or more water-soluble polymers selected from the group consisting of hydroxypropyl methyl cellulose, carboxymethyl cellulose, polyacrylamide, polyvinylalcohol, polyvinylpyrrolidone, polystyrenesulfonic acid and dextran.

Said styrene/(meth)acrylic copolymers (D) are water soluble. In said copolymers (D) each molecule comprises or consists of units derived from monoalkenyl aromatic monomers and units derived from (meth)acrylic monomers in copolymerized form. Such copolymers are obtainable by copolymerisation of one or more kinds of monoalkenyl aromatic monomers with one or more kinds of (meth)acrylic monomers. Herein, the term "(meth)acrylic" includes "methacrylic" and "acrylic". The number average molecular weight of each of said copolymers (D) is in the range of from 500 g/mol to 22000 g/mol, preferably of from 1700 g/mol to 15500 g/mol, further preferably of from 5000 g/mol to 10000 g/mol. For further details regarding said copolymers (D), reference is made to US 2008/0182090, US 4,414,370, US 4,529,787, US 4,546,160, US 5,508,366 and the prior art cited therein, as well as to the patent application "Composition comprising silver nanowires and styrene/(meth)acrylic copolymers for the preparation of electroconductive transparent layers" filed by the same assignee on the same day like the present application.

Typically, the water-soluble copolymers (D) are amphiphilic, because their molecules contain non-polar hydrophobic regions derived from the monoalkenyl aromatic monomers and polar hydrophilic regions derived from the (meth)acrylic monomers. Thus, the desired amphiphilic behavior is obtainable by appropriate selection of the hydrophobic monoalkenyl aromatic monomers and the hydrophilic (meth)acrylic monomers and appropriate adjustment of the ratio between monoalkenyl aromatic monomers and (meth)acrylic monomers so that a copolymer is obtained which has an appropriate ratio between hydrophobic units derived from monoalkenyl aromatic monomers and hydrophilic units derived from (meth)acrylic monomers to allow for amphiphilic behavior of the copolymer. In aqueous solution said water-soluble copolymers (D) behave like surfactants (tensides), i.e. they are capable of forming micelles. A micelle is an aggregate formed by association of dissolved amphiphilic molecules. Preferably said micelles have a diameter of up to 5 nm. As mentioned above, in the composition according to the present invention the above-defined amphiphilic water-soluble copolymer (D) acts as a dispersing agent for the dispersed polymer beads (C).

Said fibers (E) are also referred to as nanocrystalline cellulose or cellulose nanofibers or cellulose II. They are obtainable by disrupting the amorphous domains of natural cellulose fibers and disintegration of the micrometer-sized cellulose fibers into rod-like rigid crystallites. The obtained crystallites typically have the above-mentioned dimensions.

More specifically, crystalline cellulose fibers (E) having the above-mentioned dimensions are obtainable by chemical treatment or by enzymatic treatment or by mechanical treatment of natural cellulose fibers or by combinations of different types of treatment, e.g. chemical treatment (e.g. with sulfuric acid or sodium chlorite) or enzymatic treatment followed by high-pressure homogenization, or by milling of natural cellulose fibers and subsequent hydrolysis to remove amorphous regions.

When an aqueous dispersion of fibers (E) of crystalline cellulose is dried, the cellulose fibers (E) are densely packed together by capillary action during the evaporation of the water. Accordingly, said cellulose fibers (E) are capable of co-acting with said dispersed polymer beads (C) in binding the electroconductive nanoobjects (B). Furthermore, due to their outstanding mechanical stability, said fibers (E) impart mechanical reinforcement to the obtained electroconductive transparent layer. For further details, reference is made to the patent application "Composition comprising silver nanowires and fibers of crystalline cellulose for the preparation of electroconductive transparent layers" filed by the same assignee on the same day like the present application.

Without wishing to be bound to any theory, it is presently assumed that in a composition according to the present invention the above-defined dispersed fibers (E) act as repulsion enhancers which contribute in keeping the polymer beads (C) in the dispersed state.

Suitable additional binding agents, especially those defined above as (D), (E) and (F), are known in the art and are commercially available.

In a specific preferred embodiment, the composition according to the present invention comprises or consists of the above-defined constituents (A), (B) and (C), and

(D) dissolved in the water one or more styrene/(meth)acrylic copolymers, said dissolved copolymers (D) each having a number average molecular weight in the range of from 500 g/mol to 22000 g/mol

and no further additional binding agent,
wherein the total weight fraction of said dissolved copolymers (D), based on the total weight of the composition, is equal to or less than the total weight fraction of said dispersed polymer beads (C) based on the total weight of the composition.

In another specific preferred embodiment, the composition according to the present invention comprises or consists of the above-defined constituents (A), (B) and (C), and

(E) dispersed in the water fibers of crystalline cellulose,
said dispersed fibers (E) of crystalline cellulose having a length in the range of from 80 nm to 300 nm and a diameter in the range of from 5 nm to 30 nm,

and no further additional binding agent,
wherein the weight fraction of said fibers (E), based on the total weight of the composition, is equal to or less than the total weight fraction of said dispersed polymer beads (C) based on the total weight of the composition.

In another preferred embodiment, the composition according to the present invention comprises or consists of the above-defined constituents (A), (B) and (C), and

(F) one or more water-soluble polymers as defined above
and no further additional binding agent.

wherein the total weight fraction of said one or more water-soluble polymers (F), based on the total weight of the composition, is equal to or less than the total weight fraction of said dispersed polymer beads (C) based on the total weight of the composition.

The composition according to the present invention optionally comprises further constituents beside the above-defined constituents (A) to (C), e.g. defoaming agents, rheological controlling agents, corrosion inhibitors and other auxiliary agents. Typical defoaming agents, rheological controlling agents and corrosion inhibitors are known in the art and commercially available. However, surprisingly it has been found that compositions according to the invention (as defined above) which do not contain any further constituents beyond the above-defined constituents (A)-(C), dispersing assistants (as defined above) which serve to keep the polymer beads (C) in a dispersed state within the composition and optionally one or more of above-defined constituents (D)-(F) are suitable for the preparation of electroconductive transparent layers having superior optical properties as well as satisfying electronic conductivity. Accordingly, the addition of any auxiliary agents can be omitted, thus rendering the composition less complex and facilitating preparation of such composition. Accordingly, in preferred embodiments a composition according to the present invention consists of above-defined constituents (A)-(C) and optionally one or more of above-defined constituents (D)-(F). Nevertheless, in certain embodiments the composition according to the present invention (as defined above) comprises one or more auxiliary agents, especially those as defined above.

It is understood that any further constituents (beside the above-defined constituents (A) to (C)) of the composition according to the present invention (as defined above) as well as the amounts of such further constituents have to be selected in such manner that the electrical conductivity and the optical properties of a layer obtainable from said composition are not compromised.

Preferred compositions according to the present invention are those wherein two or more of the above-defined preferred features are combined.

Particularly preferred is a composition according to the present invention, said composition comprising or consisting of

(A) water

(B) silver nanowires
said silver nanowires (B) having a length in the range of from 10 μm to 50 μm and a diameter in the range of from 3 nm to 30 nm
wherein the weight fraction of said silver nanowires (B) is 0.5 wt.-% or less, based on the total weight of the composition

C) dispersed in the water, particles of a polymer having a number average molecular weight of 30000 g/mol to 100000 g/mol
wherein said dispersed particles (C) have a mean diameter in the range of from 50 nm to 500 nm,
wherein the weight fraction of said dispersed particles (C) is less than 2 wt.-%, preferably 1.5 wt.-% or less, based on the total weight of the composition,

wherein the ratio between
the total weight of said silver nanowires (B)
and
the weight of said dispersed particles (C)
is in the range of from 1:5 to 5:1.

A composition according to the present invention is preparable e.g. by suspending in water an appropriate amount of the above-defined electroconductive nanoobjects (B) and an appropriate amount of said polymer beads (C), or by combining appropriate amounts of a pre-manufactured aqueous suspension of said electroconductive nanoobjects (B) and of a pre-manufactured aqueous suspension of said polymer beads (C), or by suspending an appropriate amount of said electroconductive nanoobjects (B) in a pre-manufactured aqueous suspension of said polymer beads (C) or by suspending an appropriate amount of said polymer beads (C) in a pre-manufactured aqueous suspension of said electroconductive nanoobjects (B). In preferred embodiments, after combining the constituents (A)-(C) and optionally further constituents (as defined above), the composition is subjected to ball-milling or other suitable techniques in order to improve homogenization of the composition. In certain embodiments, a prolonged homogenization treatment is preferably in order to ensure that the obtained layers have a low haze.

A further aspect of the present invention relates to a method for preparing on a substrate an electroconductive layer having a light transmission of 80 % or more measured according to ASTM D1003 (Procedure A). Said method according to the present invention comprises the steps of:

preparing or providing a composition according to the present invention as defined above,

applying said composition to a surface of a substrate,

removing constituents which at 25 °C and 101.325 kPa are liquid from said composition applied to said surface of said substrate to such extent that a layer is formed on said surface of said substrate.

The layer formed by the above-defined process of the invention is a solid electroconductive layer having a light transmission of 80 % or more measured according to ASTM D1003 (Procedure A), said layer comprising or consisting of solid constituents of said composition according to the present invention as defined above.

In the context of the present application, the process step of removing constituents which at 25 °C and 101.325 kPa are liquid from said composition applied to said surface of said substrate to such extent that a layer is formed on said surface of said substrate is also referred to as drying. Usually, the liquid constituents are removed by evaporation.

Generally, the liquid constituents have to be removed at least to such extent that on said surface of said substrate an electroconductive layer having a light transmission of 80 % or more measured according to ASTM D1003 (Procedure A) is formed, wherein the above-defined polymer beads (C) are coalesced and form a contiguous solid phase (also referred to as a matrix) binding the electroconductive nanoobjects (B) which in turn form a conductive network extending throughout said solid matrix. Preferably, said electroconductive layer has a thickness in the range of from 10 nm to 1000 nm, preferably of from 50 nm to 500 nm. Generally, the lower limit of the thickness of the electroconductive layer is determined by the smallest dimension of the nanoobjects of the applied composition.

When a latex (aqueous dispersion of above-defined polymer beads (C)) is deposited on a substrate and evaporation of the water is allowed to proceed, a continuous, homogeneous film (layer) is formed under appropriate conditions. This process is called film formation. The mechanism of film formation from latex is described e.g. in Materials Science and Engineering, 21 101-170 and in Advances in Colloid and Interface Science 86 (2000) 195-267. Generally, the formation of a latex film arises from the 'coalescence' i.e. compaction, deformation, cohesion and polymer chain interdiffusion of the individual latex particles (polymer beads (C)) which in the aqueous dispersion are held apart by stabilising forces (electrostatic and/or steric) resulting e.g. from the charged polymer chain endgroups or adsorbed surfactants. These and other forces resisting particle deformation are overcome upon evaporation of the continuous phase of the latex (water.).

Without wishing to be bound to any theory, it is presently assumed that additional binding agents (D) and (E) as defined above increase the homogeneity of the formed layer so that the optical properties, especially with regard to the haze, are improved.

Preferably the constituents which at 25 °C and 101.325 kPa are liquid are completely removed from said composition applied to said surface of said substrate.

Applying said composition according to the invention to said surface of said substrate is preferably carried out by means of a technique selected from the group consisting of spin coating, draw down coating, roll-to-roll coating, gravure printing, microgravure printing, screen-printing, flexoprinting and slot-die coating.

Preferably, said composition is applied to said surface of said substrate in a thickness in a range of from 1 $\mu$m to 200 $\mu$m, preferably of from 2 $\mu$m to 60 $\mu$m. Said thickness is also referred to as "wet thickness" and relates to the state before removing the liquid constituents of the composition as explained above. At a given target thickness (after removing the liquid constituents of the composition as explained above) and accordingly a given target sheet resistance and light transmission of the electroconductive layer to be prepared, the wet thickness may be the higher the lower the concentration of solid constituents in the composition is in the ink. The process of applying the ink is facilitated when there is no constraint to apply the ink in particular low wet thickness.

Said substrate to which said composition according to the present invention (as defined above) is applied is typically an electrical isolator. Preferably said substrate comprises or consists of a material selected from the group consisting of glass and organic polymers. Preferred organic polymers are selected from the group consisting of polycarbonate (PC), cyclic olefin copolymer (COP), polyvinylidene fluoride (PVDF), polyimide (PI) and polyethylene terephthalate (PET). Preferably, said substrate has a light transmission of 80 % or more measured according to ASTM D1003 (Procedure A).

Removing (to such extent as explained above) of those constituents which are liquid at 25 °C and 101.325 kPa from said composition applied to said surface of said substrate is preferably achieved by subjecting said composition applied to said surface of said substrate to a temperature in the range of from 100 °C to 150 °C for a duration of 15 minutes or less. In this regard, the skilled person is aware that said temperature has to be selected under consideration of the thermal stability of the substrate.

Preferred methods according to the present invention are those wherein two or more of the above-defined preferred features are combined.

Regarding the method for preparing an electroconductive layer (as defined above) according to the present invention, the skilled person based on its knowledge adjusts the composition of the ink and all process parameters (of the preparation of the ink as well as of the preparation of the electroconductive layer) in a suitable manner, in order to optimize the sheet resistance and the optical properties of the electroconductive layer, taking into account the technical features of the selected substrate and the available technique for applying the composition according to the invention to the surface of the substrate. If necessary, suitable compositions of the ink and/or process parameters can be easily identified by test procedures known to the person skilled in the art, which do not require undue experimentation.

A further aspect of the present invention relates to an electroconductive layer having a light transmission of 80 % or more as measured according to ASTM D1003 (Procedure A), wherein said electroconductive layer comprises or consists of the solid constituents of a composition according to the present invention as defined above. In said electroconductive layer the above-defined polymer beads (C) are coalesced and form a contiguous solid phase (also referred to as a matrix) binding the electroconductive nanoobjects (B) which in turn form a conductive network extending throughout said solid matrix. Said electroconductive layer is obtainable by the above-defined method according to the present invention.

Light transmission" refers to the percentage of an incident light which is transmitted through a medium. Preferably the light transmission of an electroconductive layer according to the present invention is 85 % or more, more preferably 90 % or more, further preferably 95 % or more, in each case measured according to ASTM D1003 (Procedure A).

A preferred electroconductive layer according to the present invention exhibits a haze of 2 % or less as measured according to ASTM D1003 (Procedure A), and/or a sheet resistance of 1000 Ohm/square or less as measured by the four point probe.

Preferably the haze of an electroconductive layer according to the present invention is 1.8 % or less, more preferably 1.5 % or less, further preferably 1.2 % or less, in each case measured according to ASTM D1003 (Procedure A).

Preferably the sheet resistance of an electroconductive layer according to the present invention is 800 Ohm/square or less, more preferably 500 Ohm/square or less, further preferably 200 Ohm/square or less, in each case measured by the four point probe.

The measurement of haze and light transmission (in ASTM D1003 referred to as luminous transmittance which is the ratio of the luminous flux transmitted by a body to the flux incident upon it) by means of a hazemeter is defined in ASTM-D1003 as "Procedure A - Hazemeter". The values of haze and light transmission (corresponding to the luminous transmittance as defined in ASTM D1003) given in the context of the present invention refer to this procedure.

Generally, haze is an index of the light diffusion. It refers to the percentage of the quantity of light separated from the incident light and scattered during transmission. Unlike light transmission, which is largely a property of the medium, haze is often a production concern and is typically caused by surface roughness, and by embedded particles or compositional heterogeneities in the medium.

According to ASTM D1003, in transmission, haze is the scattering of light by a specimen responsible for the reduction in contrast of objects viewed through said specimen, i.e. the percent of transmitted light that is scattered so that its direction deviates more than a specified angle (2.5 °) from the direction of the incident beam.

The sheet resistance is a measure of resistance of a thin body (sheet) namely uniform in thickness. The term "sheet resistance" implies that the current flow is along the plane of the sheet, not perpendicular to it. For a sheet having a thickness t, a length L and a width W, the resistance R is

$$R = \rho * \frac{L}{Wt} = \frac{\rho}{t} * \frac{L}{W} = R_{sh} * \frac{L}{W}$$

wherein Rsh is the sheet resistance. Accordingly the sheet resistance $R_{sh}$ is

$$R_{sh} = R * \frac{W}{L}$$

In the formula given above the bulk resistance R is multiplied with a dimensionless quantity (W/L) to obtain the sheet resistance $R_{sh}$, thus the unit of sheet resistance is Ohms.

For the sake of avoiding confusion with the bulk resistance R, the value of the sheet resistance is commonly indicated as "Ohms per Square" because in the specific case of a square sheet W = L and R = $R_{sh}$. The sheet resistance is measured by means of a four point-probe.

Further details of the measurement of the sheet resistance and the haze are given below in the examples section.

More preferably, an electroconductive layer according to the present invention exhibits one or more of the following features:

- a haze of 1 % or less as measured according to ASTM D1003 (procedure A),

- a sheet resistance of 100 Ohm/square or less as measured by the four point probe,

- a light transmission of 90 % or more as measured according to ASTM D1003 (procedure A).

Preferred electroconductive layers according to the present invention are those wherein two or more of the above-defined preferred features are combined.

A particularly preferred electroconductive layer according to the present invention exhibits the following features:

- a haze of 1 % or less as measured according to ASTM D1003 (Procedure A), and

- a sheet resistance of 100 Ohm/square or less as measured by the four point probe, and

- a light transmission of 90 % or more as measured according to ASTM D1003 (Procedure A).

A further aspect of the present invention relates to an article comprising a substrate having a surface and an electroconductive layer according to the invention (as defined above) arranged on at least a portion of said surface of said substrate.

Preferably, said electroconductive layer has a thickness in the range of from 10 nm to 1000 nm, preferably of from 50 nm to 500 nm. The lower limit of the thickness of the electroconductive layer is determined by the smallest dimension of the nanoobjects of the applied composition.

Said substrate is typically an electrical isolator. Preferably said substrate comprises or consists of a material selected from the group consisting of glass and organic polymers. Preferred organic polymers are selected from the group consisting of polycarbonate (PC), cyclic olefin copolymer (COP), polyvinylidene fluoride (PVDF), polyimide (PI) and polyethylene terephthalate (PET). Preferably, said substrate has a light transmission of 80 % or more measured according to ASTM D1003 (Procedure A).

Preferred articles according to the present invention are those wherein two or more of the above-defined preferred features are combined.

Typical applications of electroconductive layers according to the present invention (as defined above) and articles according to the present invention (as defined above) are selected from the group consisting of transparent electrodes, touch panels, wire polarizers, capacitive and resistive touch sensors, EMI shielding, transparent heaters (e.g. for automobile and other applications), flexible displays, plasma displays, electrophoretic displays, liquid crystal displays, transparent antennas, electrochromic devises (e.g. smart windows), photovoltaic devices (especially thin-film photovoltaic cells), electroluminescent devices, light emitting devices (LED) and organic light emitting devices (OLED), flexible devices that can be worn (so-called wearables) such as flexible watches or foldable screens, as well as functional coatings imparting anti-fogging, anti-icing or antistatic properties and dielectric and ferroelectric haptic films. However the present invention is not limited by these applications and can be used in many other electro optical devices by those skilled in the art.

A further aspect of the present invention relates to the use of a composition according to the present invention (as defined above) for the preparation of an electroconductive layer according to the present invention (as defined above) or of an article according to the present invention (as defined above).

The invention is hereinafter further illustrated by means of examples.

Examples

1. Examples of layers on polymer substrates obtained by draw-down coating

1.1 Compositions comprising no additional binding agent

An aqueous dispersion of silver nanowires (nanoobjects (B) as defined above) and an aqueous dispersion of beads (dispersed particles (C) as defined above) of a butyl acrylate-styrene copolymer (Acronal 296, average particle size 0.1 $\mu$m, commercially available from BASF) are mixed for the dispersing time given in table 1 so as to obtain an ink having a concentration of silver nanowires and a weight ratio of silver nanowires to dispersed polymer beads (C) as indicated in table 1.

The ink is applied to a polymer substrate using a draw-down bar (Erichsen K303) (wet thickness t = 6 $\mu$m, coating speed v = 2"/sec) to obtain a layer on said substrate. The layer is then dried at 135 °C for 5 min.

The sheet resistance Rsh given in Ohms/square (OPS) of the dried layer is measured by a four-point probe station (Lucas lab pro-4) and the optical properties are measured according to ASTM D1003 procedure A-Hazemeter by a haze-gard plus hazemeter (BYK Gardner). The results are compiled in table 1.

With regard to the optical properties, T refers to the light transmission and H refers to the haze of the substrate coated with the electroconductive layer. H(substrate subtracted) refers to the difference between the haze of the substrate coated with the electroconductive layer and the haze of the blank substrate (not coated with the electroconductive layer).

While all obtained layers have satisfying values of sheet resistance and transparence, it has been found that the haze value strongly depends on the dispersing time of the ink and is the lower the longer the ink dispersion time is.

Table 1

| Example Number | Silver nanowire concentration (mg/ml) | Weight ratio silver nanowires (B)/ polymer beads (C) | Dispersing time (min) | Rsh (OPS) | T (%) | H (%) | H(substrate subtracted) (%) |
|---|---|---|---|---|---|---|---|
| 1 | 3.15 | 1:1 | 30 | 27.94 | 88.8 | 8.29 | 7.86 |
| 2 | 3.15 | 1:1 | 45 | 30.48 | 88.7 | 6.66 | 6.23 |
| 3 | 3.15 | 1:1 | 60 | 33.02 | 88.6 | 9.92 | 9.49 |
| 4 | 3.15 | 1:0.5 | 30 | 22.86 | 87.7 | 5.25 | 4.82 |
| 5 | 3.15 | 1:0.5 | 45 | 33.02 | 88.8 | 3.71 | 3.28 |

An aqueous dispersion of silver nanowires (nanoobjects (B) as defined above) and an aqueous dispersion of beads (dispersed particles (C) as defined above) of a copolymer of 2-ethylhexyl acrylate and methyl methacrylate (Acronal LR9014, average particle diameter 0.08 $\mu$m, commercially available from BASF) are mixed for a dispersing time of 30 minutes so as to obtain an ink having a concentration of silver nanowires of 3.85 mg/ml and a weight ratio of silver nanowires to dispersed polymer beads (C) as indicated in table 2.

The ink is applied to a polymer substrate using a draw-down bar (Erichsen K303) (wet thickness t = 6 $\mu$m, coating speed v = 2"/sec) to obtain a layer on said substrate. The layer is then dried at 135 °C for 5 min.

The sheet resistance Rsh given in Ohms/square (OPS) of the dried layer is measured by a four-point probe station (Lucas lab pro-4) and the optical properties (as defined above) are measured according to ASTM D1003 procedure A-Hazemeter by a haze-gard plus hazemeter (BYK Gardner). The results are compiled in table 2. All obtained layers had satisfying values of sheet resistance, transparency and haze.

Table 2

| Example number | Weight ratio silver nanowires (B)/ polymer beads (C) | Rsh (OPS) | T (%) | H (%) | H(substrate subtracted) (%) |
|---|---|---|---|---|---|
| 6 | 1:1 | 46.99 | 88.6 | 1.13 | 1 |
| 7 | 1:2 | 60.96 | 89.13 | 1.05 | 0.92 |
| 8 | 1:3 | 68.58 | 89.25 | 1.05 | 0.92 |
| 9 | 1:4 | 97.79 | 90.4 | 1.03 | 0.9 |
| 10 | 1:5 | 76.84 | 90.73 | 0.96 | 0.83 |

An aqueous dispersion of silver nanowires (nanoobjects (B) as defined above) and an aqueous dispersion of beads (dispersed particles (C) as defined above) of a copolymer of acrylates (Joncryl 95-E, commercially available from BASF) are mixed for a dispersing time of 30 minutes so as to obtain an ink having a concentration of silver nanowires and a weight ratio of silver nanowires to dispersed polymer beads (C) as indicated in table 3.

The ink is applied to a polymer substrate using a draw-down bar (Erichsen K303) (wet thickness t = 6 $\mu$m, coating speed v = 2"/sec) to obtain a layer on said substrate. The layer is then dried at 135 °C for 5 min.

The sheet resistance Rsh given in Ohms/square (OPS) of the dried layer is measured by a four-point probe station (Lucas lab pro-4) and the above-defined optical properties are measured according to ASTM D1003 procedure A-Hazemeter by a haze-gard plus hazemeter (BYK Gardner). The results are compiled in table 3. All obtained layers had satisfying values of sheet resistance, transparency and haze.

Table 3

| Example Number | Silver nanowire concentration (mg/ml) | Weight ratio silver nanowires / polymer beads (C) | Rsh (OPS) | T (%) | H (%) | H(substrate subtracted) (%) |
|---|---|---|---|---|---|---|
| 11 | 3.47 | 2:1 | 45.72 | 89.5 | 0.88 | 0.75 |
| 12 | 3.47 | 1:1 | 52.07 | 89.95 | 0.95 | 0.82 |

An aqueous dispersion of silver nanowires (nanoobjects (B) as defined above) and an aqueous dispersion of beads (dispersed particles (C) as defined above) of a copolymer of 2-ethylhexyl acrylate methyl methacrylate (Acronal LR9014, commercially available from BASF) and beads (dispersed particles (C) as defined above) of a copolymer of acrylates (Joncryl 95-E, commercially available from BASF) are mixed for a dispersing time of 30 minutes in different ratios as indicated in table 4, so as to obtain an ink having a concentration of silver nanowires of 3.764 mg/mL and a weight ratio silver nanowires / Acronal LR9014 / Joncryl 95-E as indicated in table 4. Both types of polymer beads are particles (C) as defined above)

The ink is applied to a polymer substrate using a draw-down bar (Erichsen K303) (wet thickness t = 6 μm, coating speed v = 2"/sec) to obtain a layer on said substrate. The layer is then dried at 135 °C for 5 min.

The sheet resistance Rsh given in Ohms/square (OPS) of the dried layer is measured by a four-point probe station (Lucas lab pro-4) and the above-defined optical properties are measured according to ASTM D1003 procedure A-Hazemeter by a haze-gard plus hazemeter (BYK Gardner). The results are compiled in table 4. All obtained layers had satisfying values of sheet resistance, transparency and haze.

Table 4

| Example Number | Silver nanowire concentration (mg/ml) | weight ratio silver nanowires / Acronal LR9014 / Joncryl 95-E | Rsh (OPS) | T (%) | H (%) | H(substrate subtracted) (%) |
|---|---|---|---|---|---|---|
| 13 | 3.764 | 1:1:1 | 50.17 | 90.43 | 1.2 | 1.07 |
| 14 | 3.764 | 1:2:1 | 147.32 | 91.48 | 1.12 | 0.99 |

1.2 Compositions comprising an additional binding agent

1.2.1 Water-soluble styrene/(meth)acrylic copolymers as the additional binding agent

An aqueous dispersion of silver nanowires (nanoobjects (B) as defined above) and (with the exception of example 20) an aqueous dispersion of beads (dispersed particles (C) as defined above) of a copolymer of 2-ethylhexyl acrylate and methyl methacrylate (Acronal LR9014, commercially available from BASF) are mixed for a dispersing time of 30 minutes so as to obtain an ink having a concentration of silver nanowires and a weight ratio of silver nanowires polymer beads (C) /copolymer (D) as indicated in table 5.

Except for example 19, said dispersion of beads (dispersed particles (C) as defined above) comprises as an additional binding agent an amount a dissolved styrene acrylic copolymer (Joncryl 60, commercially available from BASF, copolymer (D) as defined above). The weight ratio silver nanowires (B) / polymer beads (C) /copolymer (D) for each ink is indicted in table 5.

In example 20 an aqueous dispersion of silver nanowires (nanoobjects (B) as defined above) and an aqueous solution of a styrene acrylic copolymer (Joncryl 60, commercially available from BASF, copolymer (D) as defined above) have been mixed for a dispersing time of 30 minutes so at to obtain an ink having a concentration of silver nanowires and a weight ratio silver nanowires (B) / copolymer (D) as indicated in table 5. Thus example 20 is a comparison example not according to the present invention because the ink of example 20 does not comprise any polymer beads (C).

The ink is applied to a polymer substrate using a draw-down bar (Erichsen K303) (wet thickness t = 6 μm, coating speed v = 2"/sec) to obtain a layer on said substrate. The layer is then dried at 135 °C for 5 min.

The sheet resistance Rsh given in Ohms/square (OPS) of the dried layer is measured by a four-point probe station (Lucas lab pro-4) and the above-defined optical properties are measured according to ASTM D1003 procedure A-Hazemeter by a haze-gard plus hazemeter (BYK Gardner). The results are compiled in table 5. All obtained layers had satisfying values of sheet resistance, transparency and haze.

Table 5

| Example Number | Silver nanowire concentration (mg/ml) | Weight ratio silver nanowires / polymer beads (C) /copolymer (D) | Rsh (OPS) | T (%) | H (%) | H(substrate subtracted) (%) |
|---|---|---|---|---|---|---|
| 15 | 4.71 | 1:4:1 | 45.09 | 90.2 | 1.37 | 1.24 |
| 16 | 4.21 | 1:4:1 | 46.36 | 90.30 | 1.26 | 1.13 |
| 17 | 3.81 | 1:4:1 | 52.71 | 90.48 | 1.15 | 1.02 |
| 18 | 3.48 | 1:4:1 | 64.77 | 90.5 | 1.09 | 0.96 |

(continued)

| Example Number | Silver nanowire concentration (mg/ml) | Weight ratio silver nanowires / polymer beads (C) /copolymer (D) | Rsh (OPS) | T (%) | H (%) | H(substrate subtracted) (%) |
|---|---|---|---|---|---|---|
| 19 | 3.89 | 1:5:0 | 71.76 | 90.45 | 1 | 0.87 |
| 20 | 3.89 | 1:0:5 | 139.07 | 89.35 | 0.71 | 0.58 |
| 21 | 3.89 | 2:5:5 | 53.98 | 89.58 | 1.21 | 1.08 |
| 22 | 3.89 | 4:15:5 | 55.88 | 89.93 | 1.14 | 1.01 |
| 23 | 3.89 | 6:25:5 | 59.06 | 90.03 | 1.11 | 0.98 |
| 24 | 3.89 | 6:5:25 | 81.92 | 89.33 | 0.81 | 0.68 |
| 25 | 3.89 | 11:50:5 | 61.60 | 90.13 | 1.05 | 0.92 |
| 26 | 3.48 | 1:4:1 | 64.77 | 89.98 | 1.01 | 0.88 |

1.2.2 Fibers of crystalline cellulose as the additional binding agent

An aqueous dispersion of silver nanowires (nanoobjects (B) as defined above) and an aqueous dispersion comprising beads (particles (C) as defined above) of a copolymer of acrylates (Joncryl 95E, commercially available from BASF) and fibers (E) of crystalline cellulose (commercially available from Celluforce) are mixed for a dispersing time of 30 minutes so as to obtain an ink having a concentration of silver nanowires and a weight ratio silver nanowires / polymer beads (C) / crystalline cellulose fibers (E) as indicated in table 6.

The ink is applied to a polymer substrate using a draw-down bar (Erichsen K303) (wet thickness t = 6 $\mu$m, coating speed v = 2"/sec) to obtain a layer on said substrate. The layer is then dried at 135 °C for 5 min.

The sheet resistance Rsh given in Ohms/square (OPS) of the dried layer is measured by a four-point probe station (Lucas lab pro-4) and the above-defined optical properties are measured according to ASTM D1003 procedure A-Hazemeter by a haze-gard plus hazemeter (BYK Gardner). The results are compiled in table 6. All obtained layers had satisfying values of sheet resistance, transparency and haze.

Table 6

| Example No | Silver nanowire concentration (mg/ml) | Weight ratio silver nanowires (B)/ polymer beads (C) / crystalline cellulose fibers (E) | Rsh (OPS) | T (%) | H (%) | H(substrate subtracted) (%) |
|---|---|---|---|---|---|---|
| 27 | 3.439 | 1:1:1 | 78.74 | 89.58 | 0.87 | 0.74 |
| 28 | 3.870 | 2:4:1 | 45.72 | 89.68 | 1.08 | 0.95 |

An aqueous dispersion of silver nanowires (nanoobjects (B) as defined above) and an aqueous dispersion comprising beads (particles (C) as defined above) of a copolymer of 2-ethylhexyl acrylate and methyl methacrylate (Acronal LR9014, commercially available from BASF) and fibers (E) of crystalline cellulose (commercially available from Celluforce) are mixed for a dispersing time of 30 minutes so as to obtain an ink having a concentration of silver nanowires and a weight ratio of silver nanowires / polymer beads (C) / crystalline cellulose fibers (E) as indicated in table 7.

The ink is applied to a polymer substrate using a draw-down bar (Erichsen K303) (wet thickness t = as indicated in table 7, coating speed v = 2"/sec) to obtain a layer on said substrate. The layer is then dried at 135 °C for 5 min.

The sheet resistance Rsh given in Ohms/square (OPS) of the dried layer is measured by a four-point probe station (Lucas lab pro-4) and the above-defined optical properties are measured according to ASTM D1003 procedure A-Hazemeter by a haze-gard plus hazemeter (BYK Gardner). The results are compiled in table 7. All obtained layers had satisfying values of sheet resistance, transparency and haze.

Table 7

| Example No. | Silver nanowire concentration (mg/ml) | Weight ratio silver nanowires (B)/ polymer beads (C)/ crystalline cellulose fibers (E) | Wet thickness (μm) | Rsh (OPS) | T (%) | H (%) | H(substrate subtracted) (%) |
|---|---|---|---|---|---|---|---|
| 29 | 4.286 | 1:1:1 | 4 | 184.79 | 90.2 | 0.82 | 0.69 |
| 30 | 4.286 | 1:1:1 | 6 | 49.53 | 90.35 | 1.25 | 1.12 |
| 31 | 4.286 | 1:1:1 | 8 | 41.28 | 90.6 | 1.49 | 1.36 |
| 32 | 3.427 | 1:2:0.5 | 6 | 111.76 | 90.98 | 0.97 | 0.84 |
| 33 | 3.427 | 1:1:1 | 6 | 55.88 | 90.33 | 1.04 | 0.91 |

2. Examples of layers on glass substrates obtained by spin-coating

An aqueous dispersion of silver nanowires (nanoobjects (B) as defined above) and an aqueous dispersion of beads (particles (C) as defined above) of a copolymer of acrylates (Joncryl 95 or 95-E, commercially available from BASF) are mixed for a dispersing time of 30 minutes so as to obtain an ink having a concentration of silver nanowires and a weight ratio of silver nanowires to dispersed polymer beads (C) as indicated in table 8.

The ink is spin-coated (Smart Coater 100) on glass substrates at various spin speeds (see table 9) for 60 sec to generate layers with different wet thickness. The layers are then dried at 130 °C for 5 min.

The sheet resistance Rsh given in Ohms/square (OPS) of the dried layer is measured by a four-point probe station (Lucas lab pro-4) and the optical properties as defined above are measured according to ASTM D1003 procedure A-Hazemeter by a haze-gard plus hazemeter (BYK Gardner). The results are compiled in table 8.

The applied amount of ink is the same in all spin coating examples. The thickness of the dried layer depends on the spin speed when using an ink of a fixed concentration. At high spin speeds there is more ink flowing away from the substrate. Thus, variation of the spin speed can be used to vary the obtained sheet resistance and optical properties (as defined above) so as to match the requirements of different applications of transparent electroconductive layers. High spin speeds allow for generating very thin layers having high light transmission and low haze, but rather high sheet resistance. In turn, low spin speeds allow for generating thicker layers having a low sheet resistance, but a lower light transmission and a higher haze.

Table 8

| Example Number | Silver nanowire concentration (mg/ml) | Weight ratio silver nanowires / polymer beads (C) | Spin speed (rpm) | Rsh (OPS) | T (%) | H (%) | H(substrate subtracted) (%) |
|---|---|---|---|---|---|---|---|
| 34 | 4 | 1:2 | 1000 | 26 | 90.7 | 1.5 | 1.33 |
| 35 | 4 | 1:2 | 1500 | 38 | 90.6 | 1.47 | 1.3 |
| 36 | 4 | 1:2 | 2000 | 44 | 91.6 | 1.16 | 0.99 |
| 37 | 4 | 1:2 | 2500 | 98 | 92.4 | 0.67 | 0.5 |
| 38 | 4 | 1:2 | 3000 | 107 | 92.6 | 0.56 | 0.39 |

An aqueous dispersion of silver nanowires (nanoobjects (B) as defined above) and an aqueous dispersion of beads (dispersed particles (C) as defined above) of a butyl acrylate-styrene copolymer (Acronal 296, commercially available from BASF) are mixed for a dispersing time of 30 minutes so as to obtain an ink having a concentration of silver nanowires and a weight ratio of silver nanowires to dispersed polymer beads (C) as indicated in table 9.

The ink is spin-coated (Smart Coater 100) on glass substrates at 1000 rpm for 60 sec to generate layers with different wet thickness, due to the different concentration of solid constituents. The layers are then dried at 130 °C for 5 min.

The sheet resistance Rsh given in Ohms/square (OPS) of the dried layer is measured by a four-point probe station (Lucas lab pro-4) and the optical properties as defined above are measured according to ASTM D1003 procedure A-Hazemeter by a haze-gard plus hazemeter (BYK Gardner). The results are compiled in table 9.

Table 9

| Example Number | Silver nanowire concentration (mg/ml) | Weight ratio silver nanowires (B) / polymer beads (C) | Rsh (OPS) | T (%) | H (%) | H(substrate subtracted) (%) |
|---|---|---|---|---|---|---|
| 39 | 0.5 | 1:1 | 196 | 93.1 | 0.94 | 0.64 |
| 40 | 1.0 | 1:1 | 101 | 92.4 | 1.35 | 1.05 |
| 41 | 1.5 | 1:1 | 61 | 91.8 | 2.18 | 1.88 |
| 42 | 2.0 | 1:1 | 44 | 91.1 | 2.83 | 2.53 |
| 43 | 3.0 | 1:1 | 32 | 90.2 | 3.86 | 3.56 |

**Claims**

1. Composition comprising the constituents

   (A) water,
   (B) electroconductive nanoobjects,
   said electroconductive nanoobjects (B) having two external dimensions in the range of from 1 nm to 100 nm and their third external dimension in the range of from 1 $\mu$m to 100 $\mu$m,
   wherein the weight fraction of said electroconductive nanoobjects (B) is in the range of from 0.01 wt.-% to 1 wt.-% based on the total weight of the composition,
   (C) dispersed in the water, particles of a polymer selected from the group consisting of polyacrylates, polymethacrylates, copolymers of acrylates and methacrylates, and copolymers of styrene and (meth)acrylates,
   said polymer having a number average molecular weight of 25000 g/mol or higher,
   wherein said dispersed particles (C) have a mean diameter in the range of from 10 nm to 1000 nm,
   wherein the total weight fraction of said dispersed particles (C) is in the range of from 0.02 wt.-% to 5 wt.-%, based on the total weight of the composition.

2. Composition according to claim 1, wherein said electroconductive nanoobjects (B) have
   a length in the range of from 1 $\mu$m to 100 $\mu$m.
   and
   a diameter in the range of from 1 nm to 100 nm.

3. Composition according to claim 1, wherein said electroconductive nanoobjects (B) comprise one or more materials selected from the group consisting of silver, copper, gold and carbon.

4. Composition according to any preceding claim
   wherein said electroconductive nanoobjects (B) are selected from the group consisting of nanowires and nanotubes.

5. Composition according to any preceding claim, wherein the ratio between
   the total weight of said electroconductive nanoobjects (B)
   and
   the total weight of said dispersed particles (C)
   is in the range of from 1 : 20 to 20 : 1.

6. Composition according to any preceding claim, comprising

   (A) water,
   (B) silver nanowires,
   said silver nanowires (B) having a length in the range of from 10 $\mu$m to 50 $\mu$m and a diameter in the range of from 3 nm to 30 nm,
   wherein the weight fraction of said silver nanowires (B) is 0.5 wt.-% or less. based on the total weight of the composition,
   (C) dispersed in the water, particles of a polymer selected from the group consisting of polyacrylates, polymethacrylates, copolymers of acrylates and methacrylates, and copolymers of styrene and (meth)acrylates,

said polymer having a number average molecular weight of 30000 g/mol to 100000 g/mol,
wherein said dispersed particles (C) have a mean diameter in the range of from 50 nm to 500 nm,
wherein the weight fraction of said dispersed particles (C) is less than 2 wt.-%, preferably 1.5 wt.-% or less,
based on the total weight of the composition,

wherein the ratio between
the total weight of said silver nanowires (B)
and
the weight of said dispersed particles (C)
is in the range of from 1:5 to 5:1.

7. Method for preparing an electroconductive layer having a light transmission of 80 % or more measured according to ASTM D1003 (procedure A) on a substrate, comprising the steps of:

preparing or providing a composition according to any of claims 1-6,
applying said composition to a surface of a substrate,
removing constituents which at 25 °C and 101.325 kPa are liquid from said composition applied to said surface of said substrate to such extent that a layer is formed on said surface of said substrate.

8. Method according to claim 7, wherein applying said composition to said surface of said substrate is carried out by means of a technique selected from the group consisting of spin coating, draw down coating, roll-to-roll coating, gravure printing. microgravure printing, screen-printing. flexoprinting and slot-die coating.

9. Method according to claim 7 or 8, wherein said substrate comprises a material selected from the group consisting of glass and organic polymers.

10. Method according to any of claims 7 to 9, wherein removing of those constituents. which are liquid at 25 °C and 101.325 kPa from said composition applied to said surface of said substrate is achieved by subjecting said composition applied to said surface of said substrate to a temperature in the range of from 100 °C to 150 °C for a duration of 15 minutes or less.

11. Electroconductive layer having a light transmission of 80 % or more measured according to ASTM D1003 (procedure A), wherein said electroconductive layer comprises constituents of a composition according to claims 1-6 which at 25 °C and 101.325 kPa are solid.

12. Electroconductive layer according to claim 11, wherein said electroconductive layer exhibits

- a haze of 2 % or less as measured according to ASTM D1003 (procedure A) and
- a sheet resistance of 1000 Ohm/square or less as measured by the four point probe.

13. Electroconductive layer according to claim 11 or 12, wherein said electroconductive layer exhibits one or more of

- a haze of 1 % or less as measured according to ASTM D1003 (procedure A),
- a sheet resistance of 100 Ohm/square or less as measured by the four point probe,
- a light transmission of 90 % or more as measured according to ASTM D1003 (procedure A).

14. Article comprising

- a substrate having a surface
and
- an electroconductive layer according to any of claims 11-13 arranged on at least a portion of said surface of said substrate,
wherein said electroconductive layer preferably has a thickness in the range of from 10 nm to 1000 nm, preferably of from 50 nm to 500 nm.

15. Use of a composition according to any of claims 1-6 for the preparation of an item selected from

- an electroconductive layer according to any of claims 11-13

- an article according to claim 14.


**Patentansprüche**

1. Zusammensetzung, die die folgenden Bestandteile enthält

   (A) Wasser,
   (B) elektrisch leitfähige Nanoobjekte,
   wobei die elektrisch leitfähigen Nanoobjekte (B) zwei externe Abmessungen im Bereich von 1 nm bis 100 nm und ihre dritte externe Abmessung im Bereich von 1 μm bis 100 μm haben,
   wobei der Gewichtsanteil der elektrisch leitfähigen Nanoobjekte (B) im Bereich von 0,01 Gew.-% bis 1 Gew.-% liegt, auf der Basis des Gesamtgewichts der Zusammensetzung,
   (C) dispergiert in Wasser, Teilchen eines Polymers, das aus der Gruppe bestehend aus Polyacrylaten, Polymethacrylaten, Copolymeren von Acrylaten und Methacrylaten und Copolymeren von Styrol und (Meth)acrylaten ausgewählt wird,

   wobei das Polymer ein zahlenmäßiges durchschnittliches Molekulargewicht von 25.000 g/mol oder mehr hat,
   wobei die dispergierten Teilchen (C) einen mittleren Durchmesser im Bereich von 10 nm - 1000 nm haben,
   wobei die gesamte Gewichtsfraktion der dispergierten Teilchen (C) im Bereich von 0,02 Gew.-% bis 5 Gew.-%, bezogen auf das Gesamtgewicht der Zusammensetzung, beträgt.

2. Zusammensetzung nach Anspruch 1, wobei die elektrisch leitfähigen Nanoobjekte (B) Folgendes haben eine Länge im Bereich von 1 μm - 100 μm,
   und
   einen Durchmesser im Bereich von 1 nm bis 100 nm.

3. Zusammensetzung nach Anspruch 1, wobei die elektrisch leitfähigen Nanoobjekte (B) ein oder mehrere Materialien umfassen, die aus der Gruppe ausgewählt werden, die aus Silber, Kupfer, Gold und Kohlenstoff besteht.

4. Zusammensetzung nach einem der vorherigen Ansprüche,
   wobei die elektrisch leitfähigen Nanoobjekte (B) aus der Gruppe ausgewählt werden, die aus Nanodrähten und Nanoröhren besteht.

5. Zusammensetzung nach einem der vorherigen Ansprüche, wobei das Verhältnis zwischen dem Gesamtgewicht der elektrisch leitfähigen Nanoobjekte (B) und dem Gesamtgewicht der dispergierten Teilchen (C) im Bereich von 1:20 bis 20:1 liegt.

6. Zusammensetzung nach einem der vorherigen Ansprüche, umfassend

   (A) Wasser,
   (B) Silber-Nanodrähte,
   wobei die Silber-Nanodrähte (B) eine Länge im Bereich von 10 μm bis 50 μm haben und einen Durchmesser im Bereich von 3 nm bis 30 nm,
   wobei der Gewichtsanteil der Silber-Nanodrähte (B) 0,5 Gew.-% oder weniger ist, bezogen auf das Gesamtgewicht der Zusammensetzung,
   (C) dispergiert im Wasser, Teilchen eines Polymers, das aus der Gruppe ausgewählt wird, die aus Polyacrylaten, Polymethacrylaten, Copolymeren von Acrylaten und Methacrylaten und Copolymeren von Styrol und (Meth)acrylaten besteht,

   wobei das Polymer ein zahlenmäßiges durchschnittliches Molekulargewicht von 30.000 g/mol bis 100.000 g/mol hat,
   wobei die dispergierten Teilchen (C) einen mittleren Durchmesser im Bereich von 50 nm bis 500 nm haben, wobei der Gewichtsanteil der dispergierten Teilchen (C) kleiner als 2 Gew.-%, vorzugsweise 1,5 Gew.-% oder weniger, bezogen auf das Gesamtgewicht der Zusammensetzung, ist,
   wobei das Verhältnis zwischen dem Gesamtgewicht der Silber-Nanodrähte (B) und dem Gewicht der dispergierten Teilchen (C) im Bereich von 1:5 bis 5:1 liegt.

7. Verfahren zum Herstellen einer elektrisch leitfähigen Schicht, die eine Lichttransmission von 80 % oder mehr hat, gemessen nach ASTM D1003 (Verfahren A), auf einem Substrat, das die folgenden Schritte umfasst:

Herstellen oder Bereitstellen einer Zusammensetzung nach einem der Ansprüche 1-6,
Auftragen der Zusammensetzung auf eine Oberfläche eines Substrats,
Entfernen von Bestandteilen, die bei 25 °C und 101.325 kPa flüssig sind, aus der Zusammensetzung, die auf die Oberfläche des Substrats aufgetragen ist, in einem solchen Ausmaß, dass eine Schicht auf der Oberfläche des Substrats gebildet wird.

8. Verfahren nach Anspruch 7, wobei das Auftragen der Zusammensetzung auf die Oberfläche des Substrats mittels eines Verfahrens ausgeführt wird, das aus der Gruppe ausgewählt wird, die aus Rotationsbeschichtung, Draw-down-Beschichtung, Roll-to-Roll-Beschichtung, Tiefdruck, Mikrotiefdruck, Siebdruck, Flexodruck und Schlitzdüsendruck besteht.

9. Verfahren nach Anspruch 7 oder 8, wobei das Substrat ein Material umfasst, das aus der Gruppe ausgewählt wird, die aus Glas und organischen Polymeren besteht.

10. Verfahren nach einem der Ansprüche 7 bis 9, wobei das Entfernen derjenigen Bestandteile, die bei 25 °C und 101.325 kPa flüssig sind, aus der Zusammensetzung, die auf die Oberfläche des Substrats aufgetragen ist, dadurch erreicht wird, dass die Zusammensetzung, die auf die Oberfläche des Substrats aufgetragen ist, einer Temperatur im Bereich von 100 °C bis 150 °C für eine Dauer von 15 Minuten oder weniger ausgesetzt wird.

11. Elektrisch leitfähige Schicht, die eine LichtTransmission von 80 % oder mehr hat, gemessen nach ASTM D1003 (Verfahren A), wobei die elektrisch leitfähige Schicht Bestandteile einer Zusammensetzung nach den Ansprüchen 1-6 enthält, die bei 25 °C und 101.325 kPa fest sind.

12. Elektrisch leitfähige Schicht nach Anspruch 11, wobei die elektrisch leitfähige Schicht Folgendes aufweist

- eine Trübung von 2 % oder weniger, gemessen nach ASTM D1003 (Verfahren A), und
- einen Schichtwiderstand von 1000 Ohm/Quadrat oder weniger, gemessen mit der Vierpunktsonde.

13. Elektrisch leitfähige Schicht nach Anspruch 11 oder 12, wobei die elektrisch leitfähige Schicht ein oder mehrere der folgenden Elemente aufweist

- eine Trübung von 1 % oder weniger, gemessen nach ASTM D1003 (Verfahren A),
- einen Schichtwiderstand von 100 Ohm/Quadrat oder weniger, gemessen mit der Vierpunktsonde,
- eine Lichttransmission von 90 % oder mehr, gemessen nach ASTM D1003 (Verfahren A).

14. Artikel, umfassend

- ein Substrat, das eine Oberfläche hat, und
- eine elektrisch leitfähige Schicht nach einem der Ansprüche 11-13, die auf mindestens einem Teil der Oberfläche des Substrats angeordnet ist,

wobei die elektrisch leitfähige Schicht vorzugsweise eine Dicke im Bereich von 10 nm bis 1000 nm hat, vorzugsweise von 50 nm bis 500 nm.

15. Verwendung einer Zusammensetzung nach einem der Ansprüche 1-6 zur Herstellung eines Artikels, der ausgewählt wird aus

- einer elektrisch leitfähigen Schicht nach einem der Ansprüche 11 bis 13
- einem Artikel nach Anspruch 14.

**Revendications**

1. Composition comprenant les constituants suivants

(A) de l'eau,
(B) des nano-objets électroconducteurs,
lesdits nano-objets électroconducteurs (B) ayant deux dimensions externes dans la plage de 1 nm à 100 nm et leur troisième dimension externe dans la plage de 1 $\mu$m à 100 $\mu$m,
dans laquelle la fraction en poids desdits nano-objets électroconducteurs (B) est dans la plage de 0.01 % en poids à 1 % en poids sur la base du poids total de la composition,
(C) dispersées dans l'eau, des particules d'un polymère choisi dans le groupe constitué de polyacrylates, polyméthacrylates, copolymères d'acrylates et de méthacrylates, et copolymères de styrène et de (méth)acrylates,

ledit polymère ayant un poids moléculaire moyen en nombre de 25000 g/mol ou plus,
dans laquelle lesdites particules dispersées (C) ont un diamètre moyen dans la plage de 10 nm à 1000 nm,
dans laquelle la fraction en poids totale desdites particules dispersées (C) est dans la plage de 0,02 % en poids à 5 % en poids, sur la base du poids total de la composition.

2. Composition selon la revendication 1, dans laquelle lesdits nano-objets électroconducteurs (B) ont une longueur dans la plage de 1 $\mu$m à 100 $\mu$m, et
un diamètre dans la plage de 1 nm à 100 nm.

3. Composition selon la revendication 1, dans laquelle lesdits nano-objets électroconducteurs (B) comprennent un ou plusieurs matériaux choisis dans le groupe constitué de l'argent, du cuivre, de l'or et du carbone.

4. Composition selon l'une quelconque des revendications précédentes
dans laquelle lesdits nano-objets électroconducteurs (B) sont choisis dans le groupe constitué de nanofils et de nanotubes.

5. Composition selon l'une quelconque des revendications précédentes, dans laquelle le rapport entre le poids total desdits nano-objets électroconducteurs (B)
et
le poids total desdites particules dispersées (C) est dans la plage de 1:20 à 20:1.

6. Composition selon l'une quelconque des revendications précédentes, comprenant

(A) de l'eau,
(B) des nanofils d'argent,
lesdits nanofils d'argent (B) ayant une longueur dans la plage de 10 $\mu$m à 50 $\mu$m et un diamètre dans la plage de 3 nm à 30 nm,
dans laquelle la fraction en poids desdits nanofils d'argent (B) est de 0,5 % en poids ou moins, sur la base du poids total de la composition,
(C) dispersées dans l'eau, des particules d'un polymère choisi dans le groupe constitué de polyacrylates, polyméthacrylates, copolymères d'acrylates et méthacrylates, et copolymères de styrène et de (méth)acrylates,

ledit polymère ayant un poids moléculaire moyen en nombre de 30000 g/mol à 100000 g/mol,
dans laquelle lesdites particules dispersées (C) ont un diamètre moyen dans la plage de 50 nm à 500 nm,
dans laquelle la fraction en poids desdites particules dispersées (C) est inférieure à 2 % en poids, de préférence 1,5 % en poids ou moins, sur la base du poids total de la composition,
dans laquelle le rapport entre
le poids total desdits nanofils d'argent (B)
et
le poids desdites particules dispersées (C) est dans la plage de 1:5 à 5:1.

7. Procédé de préparation d'une couche électroconductrice ayant une transmission de lumière de 80 % ou plus telle que mesurée selon ASTM D1003 (procédure A) sur un substrat,
comprenant les étapes de :

préparation ou fourniture d'une composition selon l'une quelconque des revendications 1 à 6,
application de ladite composition sur une surface d'un substrat,
retrait des constituants qui, à 25 °C et 101,325 kPa, sont liquides, de ladite composition appliquée sur ladite surface dudit substrat à un degré tel qu'une couche est formée sur ladite surface dudit substrat.

8. Procédé selon la revendication 7, dans lequel l'application de ladite composition sur ladite surface dudit substrat est effectuée au moyen d'une technique choisie dans le groupe constitué de l'enduction à la tourette, l'enduction par tirage, l'enduction rouleau contre rouleau, l'impression par gravure, l'impression par microgravure, la sérigraphie, l'impression flexographique et l'enduction à filière plate.

9. Procédé selon la revendication 7 ou 8, dans lequel ledit substrat comprend un matériau choisi dans le groupe constitué de verre et de polymères organiques.

10. Procédé selon l'une quelconque des revendications 7 à 9, dans lequel le retrait de ces constituants, qui sont liquides à 25 °C et 101,325 kPa de ladite composition appliquée sur ladite surface dudit substrat est effectué par soumission de ladite composition appliquée sur ladite surface dudit substrat à une température dans la plage de 100 °C à 150 °C pendant une durée de 15 minutes ou moins.

11. Couche électroconductrice ayant une transmission de lumière de 80 % ou plus, mesurée selon ASTM D1003 (procédure A), ladite couche électroconductrice comprenant des constituants d'une composition selon les revendications 1 à 6 qui sont solides à 25 °C et 101,325 kPa.

12. Couche électroconductrice selon la revendication 11, ladite couche électroconductrice présentant

    - un trouble de 2 % ou moins tel que mesuré selon ASTM D1003 (procédure A) et
    - une résistance de couche de 1000 ohms/carré ou moins telle que mesurée par la sonde à quatre points.

13. Couche électroconductrice selon la revendication 11 ou 12, ladite couche électroconductrice présentant l'un ou plusieurs parmi

    - un trouble de 1 % ou moins tel que mesuré selon ASTM D1003 (procédure A),
    - une résistance de couche de 100 ohms/carré ou moins telle que mesurée par la sonde à quatre points,
    - une transmission de lumière de 90 % ou plus telle que mesurée selon ASTM D1003 (procédure A).

14. Article comprenant

    - un substrat ayant une surface
    et
    - une couche électroconductrice selon l'une quelconque des revendications 11 à 13 agencée sur au moins une partie de ladite surface dudit substrat,

    dans lequel ladite couche électroconductrice a de préférence une épaisseur dans la plage de 10 nm à 1000 nm, de préférence de 50 nm à 500 nm.

15. Utilisation d'une composition selon l'une quelconque des revendications 1 à 6 pour la préparation d'un article choisi parmi

    - une couche électroconductrice selon l'une quelconque des revendications 11 à 13
    - un article selon la revendication 14.

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 8049333 B
- US 20080182090 A1
- US 20140255707 A1
- WO 2013192437 A2
- WO 2013175227 A1
- WO 2011115603 A1
- WO 2011008227 A1

- US 7999045 B2
- US 20080182090 A
- US 4414370 A
- US 4529787 A
- US 4546160 A
- US 5508366 A

**Non-patent literature cited in the description**

- **YUGANG SUN ; YOUNAN XIA.** *Adv. Mater,* 05 June 2002, vol. 14 (11), 833-837
- *Materials Science and Engineering,* vol. 21, 101-170

- *Advances in Colloid and Interface Science,* 2000, vol. 86, 195-267